# EUROPEAN PATENT APPLICATION

(11) **EP 2 257 140 A1**
(43) Date of publication of application: **01.12.2010**
(21) Application number: 10160469.2
(22) Date of filing: 20.04.2010
(51) Int. Cl.: H05K 3/28

(54) **Enhancing adhesion of molding materials with substates**

(30) Priority: 20.04.2009 IN CH08992009; 22.04.2009 IN CH09362009; 29.04.2009 IN CH09982009
(71) Applicant: Moser Baer India Limited, New Delhi 110020 (IN)
(72) Inventor: Singh, Jitender Pratap, 110020, New Delhi (IN); Malhi, Vijay, 110020, New Delhi (IN)
(74) Representative: Roche, Dermot

(57) **Abstract**

A method of enhancing adhesion of a molding material (202) with a substrate (102) is provided. The method includes forming one or more perforations (108) on the substrate (102), forming a coat of an affinitive material on at least one of the perforations (108), and filling the molding material (202) in the perforations (108). The affinitive material has an affinity for the molding material (202). Therefore, the molding material (202) adheres to the coat of the affinitive material.

## Description

### CROSS-REFERENCE TO RELATED APPLICATIONS

This application claims priority from Indian Patent Application No. 998/CHE/2009 filed on April 29, 2009, Indian Patent Application No. 936/CHE/2009 filed on April 22, 2009, and Indian Patent Application No. 899/CHE/2009 filed on April 20, 2009. The entire disclosure of the prior applications is incorporated herein in their entirety by reference.

### BACKGROUND OF THE INVENTION

The present invention relates, in general, to encapsulation techniques. More particularly, the present invention relates to a method of enhancing adhesion of a molding material with a substrate.

Universal Serial Bus (USB) flash drives are more common these days than any other portable storage devices. A USB flash drive is typically manufactured using Surface Mount Technology (SMT) in which a flash Integrated Circuit (IC) and other supporting electrical components are mounted on a Printed Circuit Board (PCB). Various components of the USB flash drive are then encapsulated by molding a molding material over the PCB. However, conventional encapsulation techniques often fail to properly encapsulate the various components of the USB flash drive, largely due to inadequate adhesion of the molding material to the PCB. This makes such USB flash drives prone to damage, and therefore, loss of data, due to presence of moisture or water. The problem of poor adhesion becomes more prominent when the USB flash drive is miniaturized, due to limited availability of surface area for adhesion. This leads to higher probability of loss of data, and makes the USB flash drive unusable over a period of time.

In light of the foregoing discussion, there is a need for an encapsulation technique that assists in increasing reliability of storage devices, specially miniaturized storage devices.

### SUMMARY OF THE INVENTION

An object of the present invention is to provide a method of enhancing adhesion of a molding material with a substrate.

Another object of the present invention is to provide a storage device that is highly reliable, shock resistant, water resistant and robust, compared to conventional storage devices.

Yet another object of the present invention is to provide a storage device that is miniature in size, compared to conventional storage devices.

Embodiments of the present invention provide a method of enhancing adhesion of a molding material with a substrate. The method includes forming one or more perforations on a substrate, forming a coat of an affinitive material on at least one of the perforations, and filling the molding material in the perforations. The affinitive material has an affinity for the molding material. Therefore, the molding material adheres to the coat of the affinitive material. Consequently, adhesion of the molding material to the substrate is enhanced.

In accordance with an embodiment of the present invention, the perforations may have a shape that is curved, polygonal, or a combination thereof. The size of the perforations may, for example, depend on the size of the substrate. The size of the perforations may also depend on the number, the size and the location of various components to be placed on the substrate. In addition, the size of the perforations may depend on their location on the substrate.

In accordance with an embodiment of the present invention, the perforations are formed at preset locations on the substrate. For example, the perforations may be located at a periphery of the substrate.

In accordance with an embodiment of the present invention, the molding material includes at least one of: epoxy resin, silicone, acrylic and polyurethane. As mentioned above, the affinitive material has an affinity for the molding material. Accordingly, a suitable affinitive material may be chosen depending on the molding material to be used. In accordance with an embodiment of the present invention, the affinitive material includes at least one of: silver, silver alloy, copper, copper alloy, nickel, nickel alloy, palladium, gold, gold alloy, and black oxide.

In one embodiment of the present invention, a Chip-On-Board (COB) type storage device is manufactured by a COB process. Electrical components of the COB type storage device are encapsulated by a molding material hermetically, using the above-mentioned method. This makes the COB type storage device highly reliable, shock resistant, water resistant and robust.

As the COB process requires less space, a base substrate of a small size may be used. The COB type storage device so manufactured is miniature in size, and therefore, is easy to handle and use.

### BRIEF DESCRIPTION OF DRAWINGS

Embodiments of the present invention will hereinafter be described in conjunction with the appended drawings provided to illustrate and not to limit the scope of the claims, wherein like designations denote like elements, and in which:
FIGs. 1A and 1B depict top and front views of a base substrate, in accordance with an embodiment of the present invention;
FIGs. 2A and 2B depict top and front views of the base substrate, in accordance with an embodiment of the present invention;
FIGs. 3A and 3B depict top and front views of a base substrate, in accordance with another embodiment of the present invention;
FIGs. 4A and 4B depict top and front views of the base substrate, in accordance with another embodiment of the present invention;
FIGs. 5A and 5B depict top and front views of the base substrate, in accordance with another embodiment of the present invention;
FIG. 6 depicts a system for enhancing adhesion of a molding material with a substrate, in accordance with an embodiment of the present invention;
FIG. 7 illustrates a method of enhancing adhesion of a molding material with a substrate, in accordance with an embodiment of the present invention;
FIG. 8 depicts a system for manufacturing a storage device, in accordance with an embodiment of the present invention; and
FIG. 9 depicts a method of manufacturing a storage device, in accordance with an embodiment of the present invention.

The same reference numerals refer to the same parts throughout the various figures.

### DETAILED DESCRIPTION

As used in the specification and claims, the singular forms "a", "an" and "the" include plural references unless the context clearly dictates otherwise. For example, the term "a perforation" may include a plurality of perforations unless the context clearly dictates otherwise.

Embodiments of the present invention provide a method of enhancing adhesion of a molding material with a substrate, and articles manufactured thereof. In the description of the embodiments of the present invention, numerous specific details are provided, such as examples of components and/or mechanisms, to provide a thorough understanding of embodiments of the present invention. One skilled in the relevant art will recognize, however, that an embodiment of the present invention can be practiced without one or more of the specific details, or with other apparatus, systems, assemblies, methods, components, materials, parts, and/or the like. In other instances, well-known structures, materials, or operations are not specifically shown or described in detail to avoid obscuring aspects of embodiments of the present invention.

### GLOSSARY

Base substrate: A base substrate is a substrate that provides mechanical support. The base substrate may, for example, be an electronic substrate that provides electrical connectivity. Examples of the base substrate include, but are not limited to, Printed Circuit Boards (PCBs), hybrid microcircuits, and extended PCBs. An extended PCB is a PCB including one or more conductive strips capable of facilitating a Universal Serial Bus (USB) connection.

First surface and second surface: A base substrate has a first surface and a second surface. In accordance with an embodiment of the present invention, the first surface is on an opposite side of the second surface. For example, in case when the base substrate is a PCB, the first surface may be the top surface on which electrical components are placed, while the second surface may be the bottom surface of the base substrate.

Perforation: A perforation is a three-dimensional region formed on a base substrate. A perforation may, for example, be a hole through a base substrate. Alternatively, a perforation may be a cavity formed partially through a first surface of a base substrate, such that the perforation does not open at a second surface, opposite to the first surface, of the base substrate.

Slot: A slot is an electrically-conductive strip, formed over a base substrate, to facilitate placing of electrical components.

Embedded connector: An embedded connector is an electrically-conductive arrangement embedded in a base substrate.

Bond pad: A bond pad is a pad, made of an electrically-conductive material, formed over a base substrate. The bond pad provides an interface to connect electrical components to embedded connectors.

Electrical connector: An electrical connector is a thin wire made of an electrically-conductive material for electrically connecting two points.

Electrical component: An electrical component is a component of an electronic device, and is placed on appropriate slots on a base substrate to achieve the objective of the electronic device.

Molding material: A molding material is a material that may be molded in any desired form. In an embodiment of the present invention, a molding material is molded over a first surface of a base substrate, such that the molding material fills in and adheres to perforations formed on the base substrate. The molding material may, for example, include at least one of: epoxy resin, silicone, acrylic and polyurethane.

Affinitive material: An affinitive material is a material having an affinity for a molding material. The affinitive material may, for example, include at least one of: silver, silver alloy, copper, copper alloy, nickel, nickel alloy, palladium, gold, gold alloy, and black oxide.

Chip-On-Board (COB) type device: A COB type device is an electronic device formed by a COB process. A COB process includes directly placing a bare semiconductor die on an electronic substrate, and electrically connecting the bare semiconductor die to appropriate bond pads on the electronic substrate.
Surface Mount Technology (SMT) type device: An SMT type device is an electronic device formed by an SMT process. An SMT process includes mounting an Integrated Circuit (IC) on an electronic substrate.

The method includes forming one or more perforations on a substrate, forming a coat of an affinitive material on at least one of the perforations, and filling the molding material in the perforations. The affinitive material has an affinity for the molding material. Therefore, the molding material adheres to the coat of the affinitive material. In this way, adhesion of the molding material to the substrate is enhanced.

The above-mentioned method enhances adhesion of a molding material to a substrate, and therefore, may be suitable for various applications. In an embodiment of the present invention, the method may be suitably used in the manufacturing of storage devices, where electrical components placed on an electronic substrate may be encapsulated by the molding material hermetically. In another embodiment of the present invention, the method may be suitably used in the manufacturing of various electronic devices. In yet another embodiment of the present invention, the method may be suitably used in the manufacturing of other articles that require encapsulation of components connected to a base substrate.

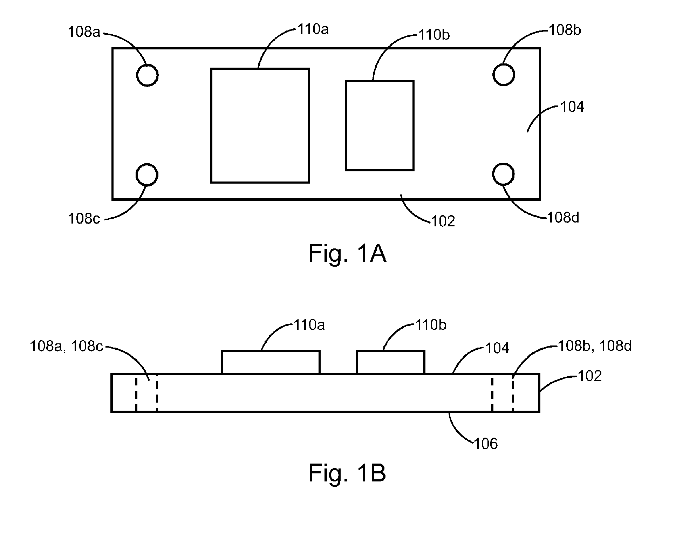

FIGs. 1A and 1B depict top and front views of a base substrate 102, in accordance with an embodiment of the present invention. Base substrate 102 has a first surface 104 and a second surface 106. In accordance with an embodiment of the present invention, base substrate 102 includes one or more perforations, shown as a perforation 108a, a perforation 108b, a perforation 108c and a perforation 108d. Perforation 108a, perforation 108b, perforation 108c and perforation 108d are hereinafter referred as perforations 108. Perforations 108 are capable of facilitating adhesion of a molding material over first surface 104 of base substrate 102.

With reference to FIG. 1A, one or more components, shown as a component 110a and a component 110b, are placed on preset locations on base substrate 102. Component 110a and component 110b are hereinafter referred as components 110. Components 110 are connected to base substrate 102, in accordance with an embodiment of the present invention. Components 110 may, for example, be thermally bonded to base substrate 102 using an electrically-conductive paste.

In accordance with a specific embodiment of the present invention, at least one of perforations 108 is capable of facilitating adhesion of the molding material over second surface 106 of base substrate 102.

In accordance with an embodiment of the present invention, at least one of perforations 108 is coated with a coat of an affinitive material. The affinitive material is a material having an affinity for the molding material. Accordingly, a suitable affinitive material may be chosen depending on the molding material to be used. In accordance with an embodiment of the present invention, the molding material includes at least one of: epoxy resin, silicone, acrylic and polyurethane. In accordance with an embodiment of the present invention, the affinitive material includes at least one of: silver, silver alloy, copper, copper alloy, nickel, nickel alloy, palladium, gold, gold alloy, and black oxide.

In accordance with an embodiment of the present invention, perforations 108 are formed at preset locations on base substrate 102. For example, perforations 108 may be located at a periphery of base substrate 102, as shown in FIG. 1A.

In addition, perforations 108 may be formed in any desired shape and/or size. For example, perforations 108 may have a shape that is curved, polygonal, or a combination thereof. With reference to FIG. 1A, perforations 108 are circular in shape.

The size of perforations 108 may depend on the size of base substrate 102. The size of perforations 108 may also depend on the number, the size and the location of various components to be placed on base substrate 102. In addition, the size of perforations 108 may depend on their location on base substrate 102.

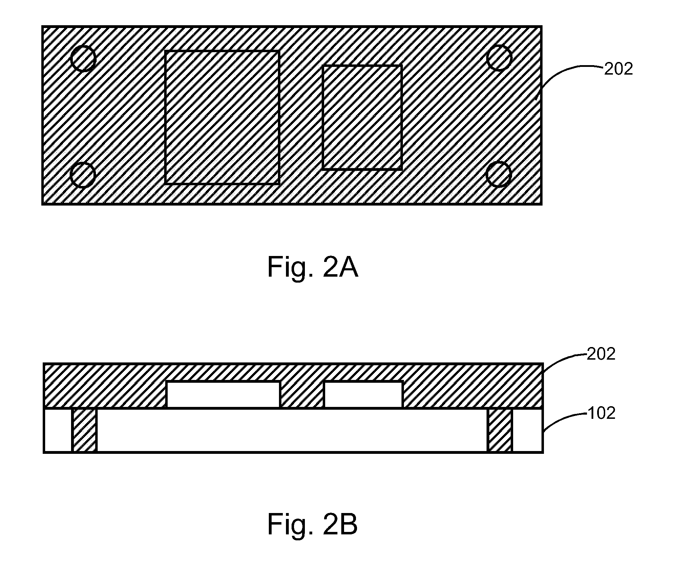

FIGs. 2A and 2B depict top and front views of base substrate 102, in accordance with an embodiment of the present invention. With reference to FIGs. 2A and 2B, a molding material 202 is molded over first surface 104 and components 110. Consequently, molding material 202 fills in and adheres to perforations 108, and encapsulates components 110.

As mentioned above, the affinitive material has an affinity for molding material 202. Therefore, the coat of the affinitive material enhances the adhesion of molding material 202 to base substrate 102. Consequently, molding material 202 encapsulates components 110 hermetically.

In accordance with a specific embodiment of the present invention, molding material 202 is also molded over second surface 106 of base substrate 102.

FIGs. 1A-1B and 2A-2B depict various stages in which an article is manufactured, in accordance with an embodiment of the present invention. In accordance with an embodiment of the present invention, the article is an SMT type device. Consider, for example, that the article is a storage device. In such a case, at least one of components 110 may be a Flash IC. A USB connector may be connected to base substrate 102.

It should be noted here that the article so manufactured is not limited to a specific shape or size of its components. FIGs. 1A-1B and 2A-2B are merely an example, which should not unduly limit the scope of the claims herein. One of ordinary skill in the art would recognize many variations, alternatives, and modifications of embodiments of the present invention.

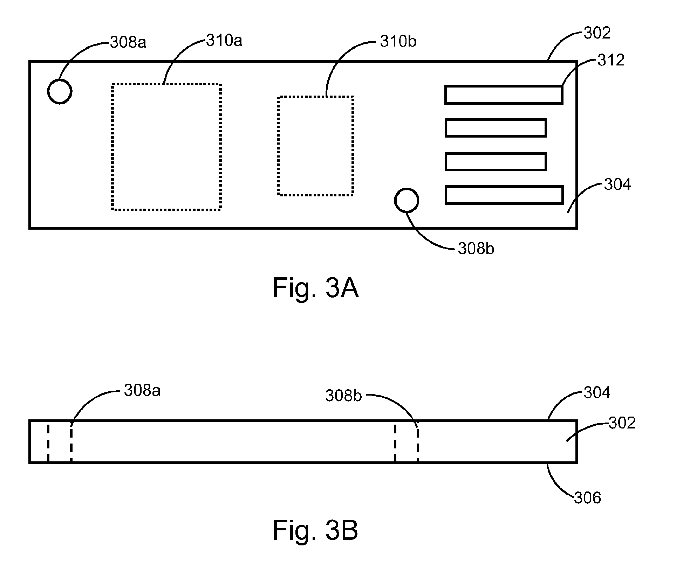

FIGs. 3A and 3B depict top and front views of a base substrate 302, in accordance with another embodiment of the present invention. Base substrate 302 has a first surface 304 and a second surface 306. In accordance with an embodiment of the present invention, base substrate 302 includes one or more perforations, shown as a perforation 308a and a perforation 308b. Perforation 308a and perforation 308b are hereinafter referred as perforations 308. Perforations 308 are capable of facilitating adhesion of a molding material over first surface 304 of base substrate 302.

In accordance with a specific embodiment of the present invention, at least one of perforations 308 is capable of facilitating adhesion of the molding material over second surface 306 of base substrate 302.

In accordance with an embodiment of the present invention, at least one of perforations 308 is coated with a coat of an affinitive material. The affinitive material is a material having an affinity for the molding material. Accordingly, a suitable affinitive material may be chosen depending on the molding material to be used. In accordance with an embodiment of the present invention, the molding material includes at least one of: epoxy resin, silicone, acrylic and polyurethane. In accordance with an embodiment of the present invention, the affinitive material includes at least one of: silver, silver alloy, copper, copper alloy, nickel, nickel alloy, palladium, gold, gold alloy, and black oxide.

In accordance with an embodiment of the present invention, perforations 308 are formed at preset locations on base substrate 302. For example, perforations 308 may be located at a periphery of base substrate 302.

In addition, perforations 308 may be formed in any desired shape and/or size. For example, perforations 308 may have a shape that is curved, polygonal, or a combination thereof. With reference to FIG. 3A, perforations 308 are circular in shape.

The size of perforations 308 may depend on the size of base substrate 302. The size of perforations 308 may also depend on the number, the size and the location of various components to be placed on base substrate 302. In addition, the size of perforations 308 may also depend on their location on base substrate 302.

In accordance with an embodiment of the present invention, base substrate 302 is an electronic substrate that includes one or more slots, shown as a slot 310a and a slot 310b, to facilitate placing of electrical components. Slot 310a and slot 310b are hereinafter referred as slots 310. In accordance with an embodiment of the present invention, at least one of slots 310 is formed on first surface 304 of base substrate 302.

Base substrate 302 also includes one or more embedded connectors (not shown) for electrically connecting electrical components placed on slots 310 in a pre-defined manner, in accordance with an embodiment of the present invention.

In accordance with an embodiment of the present invention, base substrate 302 is an extended PCB that includes one or more conductive strips 312 capable of facilitating a USB connection.

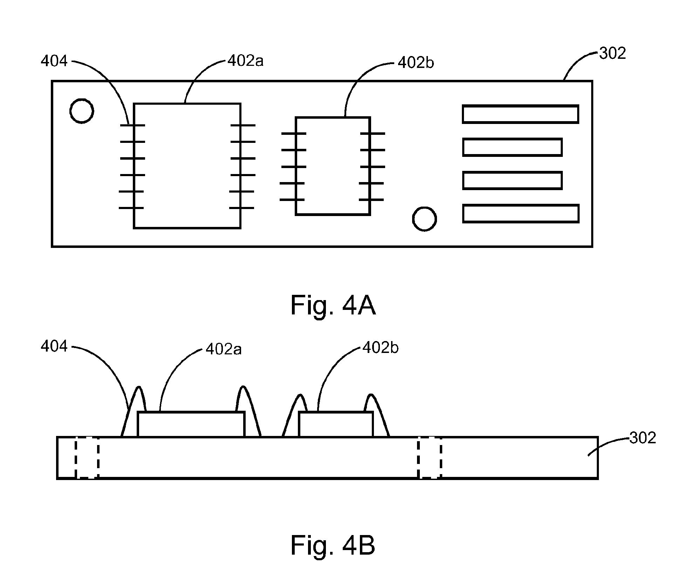

FIGs. 4A and 4B depict top and front views of base substrate 302, in accordance with another embodiment of the present invention. With reference to FIG. 4A, one or more electrical components, shown as an electrical component 402a and an electrical component 402b, are placed on appropriate slots on base substrate 302. Electrical component 402a and electrical component 402b are hereinafter referred as electrical components 402. At least one of electrical components 402 is capable of storing data, in accordance with an embodiment of the present invention.

Electrical components 402 may, for example, be thermally bonded to base substrate 302 using an electrically-conductive paste. In addition, electrical components 402 may be wire bonded to preset bond pads on base substrate 402 using wires 404, as shown in FIG. 4A.

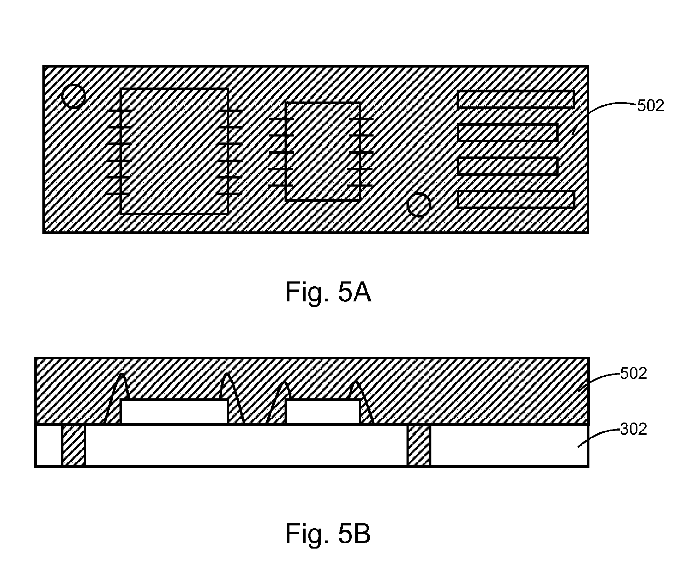

FIGs. 5A and 5B depict top and front views of base substrate 302, in accordance with another embodiment of the present invention. With reference to FIGs. 5A and 5B, a molding material 502 is molded over first surface 304 and electrical components 402. Consequently, molding material 502 fills in and adheres to perforations 308, and encapsulates electrical components 402.

As mentioned above, the affinitive material has an affinity for molding material 502. Therefore, the coat of the affinitive material enhances the adhesion of molding material 502 to base substrate 302. Consequently, molding material 502 encapsulates electrical components 402 hermetically.

In accordance with a specific embodiment of the present invention, molding material 502 is also molded over second surface 306 of base substrate 302.

FIGs. 3A-3B, 4A-4B and 5A-5B depict various stages in which a storage device is manufactured, in accordance with another embodiment of the present invention. In accordance with another embodiment of the present invention, the storage device is a COB type device.

It should be noted here that the storage device so manufactured is not limited to a specific shape or size of its components. FIGs. 3A-3B, 4A-4B and 5A-5B are merely an example, which should not unduly limit the scope of the claims herein. One of ordinary skill in the art would recognize many variations, alternatives, and modifications of embodiments of the present invention.

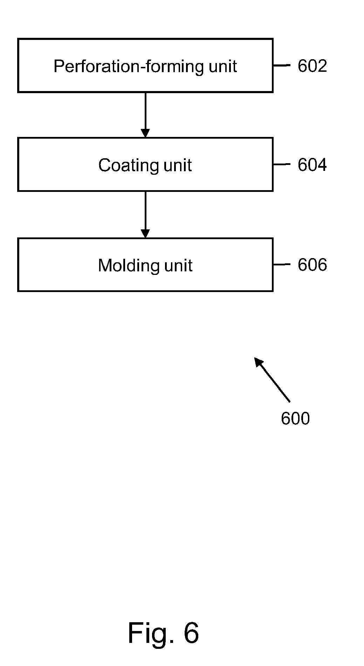

FIG. 6 depicts a system 600 for enhancing adhesion of a molding material with a substrate, in accordance with an embodiment of the present invention. System 600 includes a perforation-forming unit 602, a coating unit 604 and a molding unit 606.

Perforation-forming unit 602 is adapted to form one or more perforations on the substrate. In an embodiment of the present invention, perforation-forming unit 602 includes a drill adapted to mechanically drill the perforations through the substrate. In an alternative embodiment of the present invention, the perforations may be drilled partially through a first surface of the substrate, such that the perforations do not open at a second surface, opposite to the first surface, of the substrate. Perforation-forming unit 602 may be automated and controlled by a drill file that describes the location, size and/or shape of each perforation. Alternatively, perforation-forming unit 602 may include other suitable cutting tools.

In another embodiment of the present invention, perforation-forming unit 602 is an injection molding machine adapted to mold a substrate of a desired shape and size along with perforations at desired locations and of desired shape and size. Accordingly, the perforations may be formed using suitable molds during molding of the substrate.

Coating unit 604 is adapted to form a coat of an affinitive material on at least one of the perforations. As mentioned above, the affinitive material is a material having an affinity for the molding material. Coating unit 604 may, for example, be adapted to choose a suitable affinitive material depending on the molding material to be used. In accordance with an embodiment of the present invention, the molding material includes at least one of: epoxy resin, silicone, acrylic and polyurethane. In accordance with an embodiment of the present invention, the affinitive material includes at least one of: silver, silver alloy, copper, copper alloy, nickel, nickel alloy, palladium, gold, gold alloy, and black oxide.

In an embodiment of the present invention, the walls of the perforations are plated with the affinitive material. In a specific embodiment of the present invention, the perforations are etched using, for example, plasma-etching before the perforations are plated.

In addition, coating unit 604 may be adapted to control the thickness of the coat of the affinitive material. For example, the thickness of the coat may range from 20 mil to 60 mil (one mil is equal to one thousand of an inch).

Molding unit 606 is adapted to mold the molding material over the substrate, such that the molding material fills in the perforations. Consequently, the molding material adheres to the coat of the affinitive material on the perforations.

Molding unit 606 may, for example, be a transfer molding machine adapted to mold the molding material over the substrate.

In accordance with an embodiment of the present invention, the substrate is capable of sustaining compressive forces applied during molding. Accordingly, the substrate may, for example, be made of a material with specific physical properties. Some of these physical properties may depend on the physical dimensions of the substrate. Accordingly, a substrate of specific dimensions may be used. In one example, the substrate is a PCB. In such a case, the thickness of the PCB may, for example, range from 0.2 mm to 0.8 mm.

FIG. 6 is merely an example, which should not unduly limit the scope of the claims herein. One of ordinary skill in the art would recognize many variations, alternatives, and modifications of embodiments of the present invention.

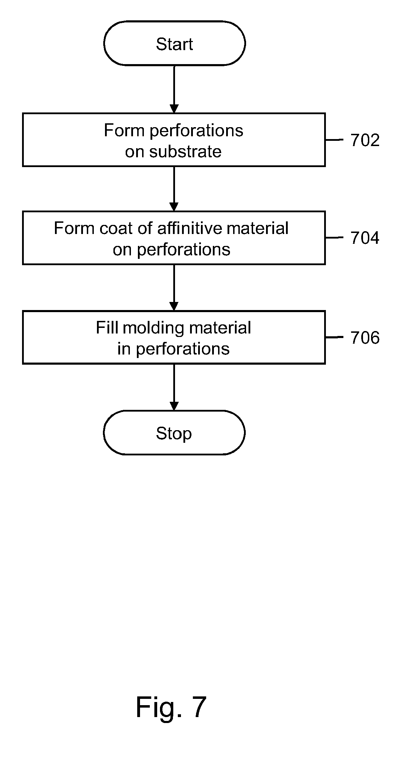

FIG. 7 illustrates a method of enhancing adhesion of a molding material with a substrate, in accordance with an embodiment of the present invention. The method is illustrated as a collection of steps in a logical flow diagram, which represents a sequence of steps that can be implemented in hardware, software, or a combination thereof.

At step 702, one or more perforations are formed on the substrate. In an embodiment of the present invention, step 702 may be performed by a drill adapted to mechanically drill the perforations through the substrate. In an alternative embodiment of the present invention, the perforations may be drilled partially through a first surface of the substrate, such that the perforations do not open at a second surface, opposite to the first surface, of the substrate. In addition, the drill may be automated and controlled by a drill file that describes the location, size and/or shape of each perforation. In another embodiment of the present invention, step 702 may be performed by an injection molding machine adapted to mold a substrate of a desired shape and size along with perforations at desired locations and of desired shape and size. Accordingly, the perforations may be formed using suitable molds during molding of the substrate.

At step 704, a coat of an affinitive material is formed on at least one of the perforations. As mentioned above, the affinitive material is a material having an affinity for the molding material. Therefore, a suitable affinitive material may be chosen depending on the molding material to be used. In accordance with an embodiment of the present invention, the molding material includes at least one of: epoxy resin, silicone, acrylic and polyurethane. In accordance with an embodiment of the present invention, the affinitive material includes at least one of: silver, silver alloy, copper, copper alloy, nickel, nickel alloy, palladium, gold, gold alloy, and black oxide.

In an embodiment of the present invention, step 704 includes plating the walls of the perforations with the affinitive material. In a specific embodiment of the present invention, an optional step of etching the perforations may be performed before step 704. The optional step may, for example, be performed using plasma-etching.

In addition, step 704 may include a sub-step of controlling the thickness of the coat of the affinitive material. For example, the thickness of the coat may range from 20 mil to 60 mil.

At step 706, the molding material is molded over the substrate, such that the molding material fills in the perforations. Consequently, the molding material adheres to the coat of the affinitive material on the perforations. Step 706 may, for example, be performed by a transfer molding machine adapted to mold the molding material over the substrate.

In accordance with an embodiment of the present invention, the substrate is capable of sustaining compressive forces applied during molding. Accordingly, the substrate may, for example, be made of a material with specific physical properties. Some of these physical properties may depend on the physical dimensions of the substrate. Accordingly, a substrate of specific dimensions may be used. In one example, the substrate is a PCB. In such a case, the thickness of the PCB may, for example, range from 0.2 mm to 0.8 mm.

It should be noted here that steps 702-706 are only illustrative and other alternatives can also be provided where steps are added, one or more steps are removed, or one or more steps are provided in a different sequence without departing from the scope of the claims herein. For example, one or more of the following steps may be added: the step of placing one or more components on the substrate, the step of connecting the components to the substrate, and the step of encapsulating the components in the molding material.

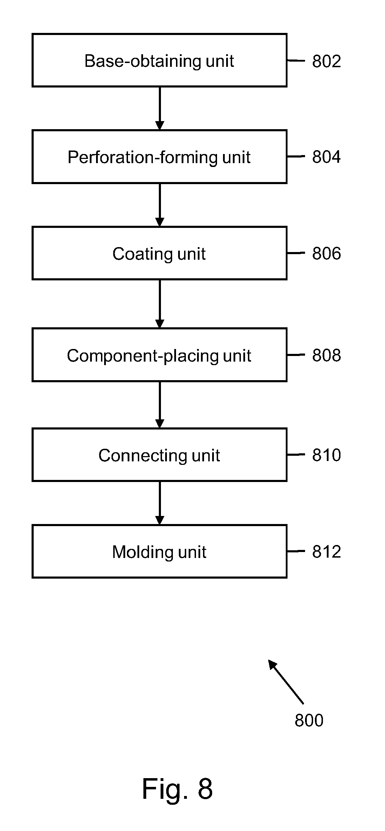

FIG. 8 depicts a system 800 for manufacturing a storage device, in accordance with an embodiment of the present invention. System 800 includes a base-obtaining unit 802, a perforation-forming unit 804, a coating unit 806, a component-placing unit 808, a connecting unit 810 and a molding unit 812.

Base-obtaining unit 802 is adapted to obtain a base substrate. The base substrate includes a first surface and a second surface. The base substrate may include one or more slots to facilitate placing of electrical components. In accordance with an embodiment of the present invention, at least one of these slots is formed on the first surface of the base substrate. The base substrate may also include one or more embedded connectors for electrically connecting electrical components placed on the slots in a pre-defined manner, in accordance with an embodiment of the present invention.

Perforation-forming unit 804 is adapted to form one or more perforations on the base substrate. In an embodiment of the present invention, perforation-forming unit 804 includes a drill adapted to mechanically drill the perforations through the base substrate. In an alternative embodiment of the present invention, the perforations may be drilled partially through the first surface of the base substrate, such that the perforations do not open at the second surface of the base substrate. Perforation-forming unit 804 may be automated and controlled by a drill file that describes the location, size and/or shape of each perforation. Alternatively, perforation-forming unit 804 may include other suitable cutting tools.

In another embodiment of the present invention, base-obtaining unit 802 and perforation-forming unit 804 are implemented together in the form of an injection molding machine adapted to mold a base substrate of a desired shape and size along with perforations at desired locations and of desired shape and size. Accordingly, the perforations may be formed using suitable molds during molding of the base substrate.

Coating unit 806 is adapted to form a coat of an affinitive material on at least one of the perforations. As mentioned above, the affinitive material is a material having an affinity for the molding material. Coating unit 806 may, for example, be adapted to choose a suitable affinitive material depending on the molding material to be used. In accordance with an embodiment of the present invention, the molding material includes at least one of: epoxy resin, silicone, acrylic and polyurethane. In accordance with an embodiment of the present invention, the affinitive material includes at least one of: silver, silver alloy, copper, copper alloy, nickel, nickel alloy, palladium, gold, gold alloy, and black oxide.

In an embodiment of the present invention, the walls of the perforations are plated with the affinitive material. In a specific embodiment of the present invention, the perforations are etched using, for example, plasma-etching before the perforations are plated.

In addition, coating unit 806 may be adapted to control the thickness of the coat of the affinitive material. For example, the thickness of the coat may range from 20 mil to 60 mil.

Component-placing unit 808 is adapted to place one or more electrical components on the slots on the base substrate. At least one of these electrical components is capable of storing data, in accordance with an embodiment of the present invention. Component-placing unit 808 may, for example, be a pick-and-place unit that is programmed to pick electrical components and place them on appropriate slots on a base substrate.

In accordance with an embodiment of the present invention, system 800 may include a dispensing unit adapted to dispense an electrically-conductive paste on the slots before the electrical components are placed on the slots, and a curing unit adapted to cure the electrically-conductive paste after the electrical components are placed on the slots. The curing unit may, for example, include an oven in which the base substrate with the placed electrical components may be heated to a preset temperature for a preset duration.

Connecting unit 810 is adapted to electrically connect the electrical components in a pre-defined manner through one or more electrical connectors. Connecting unit 810 may, for example, be adapted to wire bond the electrical components with one or more preset bond pads on the base substrate. In such a case, connecting unit 810 may, for example, implement thermo-sonic compression bonding using gold wires.

Molding unit 812 is adapted to mold the molding material over the first surface of the base substrate, such that the molding material fills in and adheres to the perforations. Consequently, the molding material encapsulates the electrical components and the electrical connectors hermetically. Molding unit 812 may, for example, be a transfer molding machine adapted to mold the molding material over the first surface of the base substrate. In an alternative embodiment of the present invention, the molding material is molded over both the first surface and the second surface of the base substrate.

In accordance with an embodiment of the present invention, the base substrate is capable of sustaining compressive forces applied during molding. Accordingly, the base substrate may, for example, be made of a material with specific physical properties. Some of these physical properties may depend on the physical dimensions of the base substrate. Accordingly, a base substrate of specific dimensions may be used for manufacturing the storage device. In one example, the base substrate is a PCB. In such a case, the thickness of the PCB may, for example, range from 0.2 mm to 0.8 mm.

FIG. 8 is merely an example, which should not unduly limit the scope of the claims herein. One of ordinary skill in the art would recognize many variations, alternatives, and modifications of embodiments of the present invention.

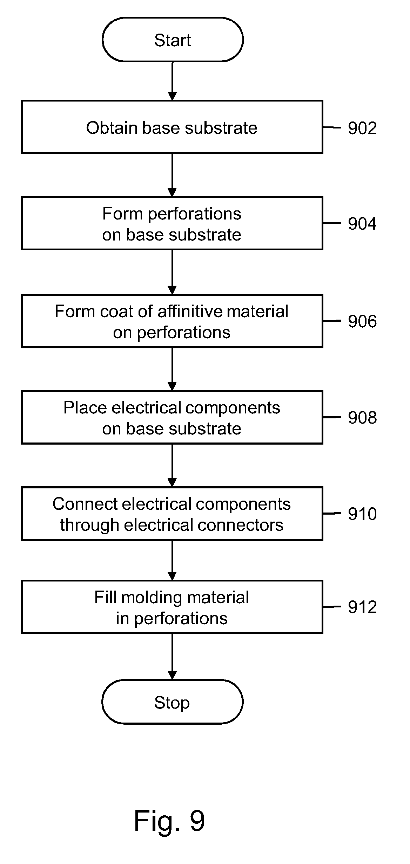

FIG. 9 depicts a method of manufacturing a storage device, in accordance with an embodiment of the present invention. The method is illustrated as a collection of steps in a logical flow diagram, which represents a sequence of steps that can be implemented in hardware, software, or a combination thereof.

At step 902, a base substrate is obtained. The base substrate includes a first surface and a second surface. The base substrate may include one or more slots to facilitate placing of electrical components. In accordance with an embodiment of the present invention, at least one of these slots is formed on the first surface of the base substrate. The base substrate may also include one or more embedded connectors for electrically connecting electrical components placed on the slots in a pre-defined manner, in accordance with an embodiment of the present invention.

At step 904, one or more perforations are formed on the base substrate. In an embodiment of the present invention, step 904 is performed by a drill adapted to mechanically drill the perforations through the base substrate. In an alternative embodiment of the present invention, the perforations may be drilled partially through the first surface of the base substrate, such that the perforations do not open at the second surface of the base substrate. In addition, the drill may be automated and controlled by a drill file that describes the location, size and/or shape of each perforation. Alternatively, step 904 may be performed by other suitable cutting tools.

In another embodiment of the present invention, step 902 and step 904 may be performed together by an injection molding machine adapted to mold a base substrate of a desired shape and size along with perforations at desired locations and of desired shape and size. Accordingly, the perforations may be formed using suitable molds during molding of the base substrate.

At step 906, a coat of an affinitive material is formed on at least one of the perforations. As mentioned above, the affinitive material is a material having an affinity for the molding material. Therefore, a suitable affinitive material may be chosen depending on the molding material to be used. In accordance with an embodiment of the present invention, the molding material includes at least one of: epoxy resin, silicone, acrylic and polyurethane. In accordance with an embodiment of the present invention, the affinitive material includes at least one of: silver, silver alloy, copper, copper alloy, nickel, nickel alloy, palladium, gold, gold alloy, and black oxide.

In an embodiment of the present invention, step 906 includes plating the walls of the perforations with the affinitive material. In a specific embodiment of the present invention, an optional step of etching the perforations may be performed before step 906. The optional step may, for example, be performed using plasma-etching.

In addition, step 906 may include a sub-step of controlling the thickness of the coat of the affinitive material. For example, the thickness of the coat may range from 20 mil to 60 mil.

At step 908, one or more electrical components are placed on the slots on the base substrate. At least one of these electrical components is capable of storing data, in accordance with an embodiment of the present invention. Step 908 may, for example, be performed by a pick-and-place unit that is programmed to pick electrical components and place them on appropriate slots on a base substrate.

In accordance with an embodiment of the present invention, a step of dispensing an electrically-conductive paste on the slots may be performed before step 908, and a step of curing the electrically-conductive paste may be performed after step 908.

At step 910, the electrical components are electrically connected in a pre-defined manner through one or more electrical connectors. Step 910 may, for example, include wire bonding the electrical components with one or more preset bond pads on the base substrate. In such a case, step 910 may, for example, include thermo-sonic compression bonding using gold wires.

At step 912, the molding material is molded over the first surface of the base substrate, such that the molding material fills in and adheres to the perforations. Consequently, the molding material encapsulates the electrical components and the electrical connectors hermetically.

Step 912 may, for example, be performed by a transfer molding machine adapted to mold the molding material over the first surface of the base substrate. In an alternative embodiment of the present invention, the molding material is molded over both the first surface and the second surface of the base substrate.

In accordance with an embodiment of the present invention, the base substrate is capable of sustaining compressive forces applied during molding at step 912. Accordingly, the base substrate may, for example, be made of a material with specific physical properties. Some of these physical properties may depend on the physical dimensions of the base substrate. Accordingly, a base substrate of specific dimensions may be used for manufacturing the storage device. In one example, the base substrate is a PCB. In such a case, the thickness of the PCB may, for example, range from 0.2 mm to 0.8 mm.

It should be noted here that steps 902-912 are only illustrative and other alternatives can also be provided where steps are added, one or more steps are removed, or one or more steps are provided in a different sequence without departing from the scope of the claims herein. In accordance with an embodiment of the present invention, steps 902-912 may be performed on a panel including a plurality of base substrates. In such a case, an additional step of de-panelizing individual base substrates may be performed after step 912. The step of de-panelizing may, for example, be performed by a laser-cutting device.

In an embodiment of the present invention, an SMT type storage device is manufactured using an SMT process. A base substrate of 0.8 mm thickness may be obtained. The base substrate may, for example, be a PCB including one or more slots to facilitate placing of electrical components, and one or more embedded connectors for electrically connecting electrical components placed on these slots in a pre-defined manner.

One or more perforations may then be formed on the base substrate. The perforations may, for example, be formed at pre-defined locations on the base substrate and of pre-defined size and/or shape. For example, the size of the perforations may range from 1 mm to 4 mm.

The perforations may then be coated with an affinitive material, for example, silver.

Next, a solder paste may be dispensed on the slots on the base substrate. Subsequently, one or more electrical components may be placed on the slots on the base substrate. One of these electrical components may, for example, be a Flash IC. Accordingly, a USB connector may be connected to the base substrate to facilitate USB connectivity.

The solder paste may then be cured, for example, in an environment, where the base substrate with the placed electrical components may be heated to a preset temperature. Accordingly, the solder paste melts and holds the electrical components on their slots.

An epoxy molding compound may, for example, be transfer molded over the electrical components and the base substrate. Accordingly, the epoxy molding compound fills in and adheres to the perforations, thereby encapsulating the electrical components hermetically. The epoxy molding compound protects the electrical components from mechanical and chemical damage.

Finally, the storage device so manufactured may be cased in a casing, in order to protect the storage device from external factors, such as heat, moisture and scratches. The casing may be attached to the base substrate and/or the molded epoxy molding compound, for example, through a gluing process or an ultrasonic welding process.

In another embodiment of the present invention, a COB type storage device is manufactured using a COB process. A base substrate of 0.4 mm thickness may be obtained. The base substrate may, for example, be an extended PCB that includes one or more conductive strips capable of facilitating a USB connection. The base substrate may include one or more slots to facilitate placing of electrical components, and one or more embedded connectors for electrically connecting electrical components placed on these slots in a pre-defined manner.

One or more perforations may then be formed on the base substrate. The perforations may, for example, be formed at pre-defined locations on the base substrate and of pre-defined size and/or shape. For example, the size of the perforations may range from 1 mm to 4 mm.

The perforations may then be coated with an affinitive material, for example, silver.

Next, a solder paste may be dispensed on at least one slot on the base substrate. Subsequently, at least one SMT component may be placed on the at least one slot on the base substrate.

The solder paste may then be cured, for example, in an environment, where the base substrate with the at least one SMT component may be heated to a preset temperature. Accordingly, the solder paste melts and holds the at least one SMT component on the base substrate.

Subsequently, a silver epoxy paste may be dispensed on at least one slot on the base substrate, and a bare semiconductor chip may be placed on the at least one slot on the base substrate.

The silver epoxy paste may then be cured, for example, in an oven, where the base substrate with the placed electrical components may be heated to a preset temperature for a preset duration.

The bare semiconductor chip may then be wire-bonded with one or more preset bond pads on the base substrate, for example, by thermo-sonic compression bonding using gold wires.

An epoxy molding compound may, for example, be transfer molded over the at least one SMT component, the bare semiconductor die and the gold wires. Accordingly, the epoxy molding compound fills in and adheres to the perforations, thereby encapsulating the at least one SMT component, the bare semiconductor die and the gold wires hermetically. The epoxy molding compound protects the at least one SMT component, the bare semiconductor die and the gold wires from mechanical and chemical damage.

Finally, the storage device so manufactured may be cased in a casing, in order to protect the storage device from external factors, such as heat, moisture and scratches. The casing may be attached to the base substrate and/or the molded epoxy molding compound, for example, through a gluing process or an ultrasonic welding process.

Embodiments of the present invention provide a method of enhancing adhesion of a molding material with a substrate, and articles manufactured thereof. In an embodiment of the present invention, the method may be suitably used in the manufacturing of storage devices, where electrical components placed on an electronic substrate are encapsulated by a molding material hermetically. The molding material protects the electrical components from mechanical and chemical damage. This makes the storage device highly reliable, shock resistant, water resistant and robust.

In another embodiment of the present invention, the method may be suitably used in the manufacturing of various electronic devices.

In yet another embodiment of the present invention, the method may be suitably used in the manufacturing of other articles that require encapsulation of components connected to a base substrate.

In one embodiment of the present invention, a COB type storage device is manufactured by a COB process. As the COB process requires less space, a base substrate of a small size may be used. The COB type storage device so manufactured is miniature in size. For example, the dimensions of the COB type storage device may be as follows: length ranging from 20 mm to 30 mm, width ranging from 10 mm to 15 mm, and height ranging from 1 mm to 2 mm. Such a miniaturized COB type storage device is easy to handle and use.

Consequently, the COB type storage device may be designed in several forms, due to its miniature size and robustness. In one example, the COB type storage device may be designed in the form of a small-sized chip that may be carried in a wallet. In another example, the COB type storage device may be designed in the form of a key ring that is easy to carry.

Moreover, the storage capacity of the COB type storage device may be increased without changing the overall dimensions of its casing.

Furthermore, the cost of manufacture is reduced, as small-sized base substrates and bare semiconductor dies are used.

This application may disclose several numerical range limitations that support any range within the disclosed numerical ranges even though a precise range limitation is not stated verbatim in the specification because the embodiments of the invention could be practiced throughout the disclosed numerical ranges. Finally, the entire disclosure of the patents and publications referred in this application, if any, are hereby incorporated herein in entirety by reference.

Therefore, the foregoing is considered as illustrative only of the principles of the invention. Further, since numerous modifications and changes will readily occur to those skilled in the art, it is not desired to limit the invention to the exact construction and operation shown and described, and accordingly, all suitable modifications and equivalents may be resorted to, falling within the scope of the invention.

## Claims

1. A storage device comprising:
a base substrate (302) comprising a first surface (304) and a second surface (306), said base substrate (302) further comprising one or more perforations (308) capable of facilitating adhesion of a molding material over said first surface (304);
one or more electrical components (402) placed on said first surface (304) of said base substrate (302), at least one of said electrical components (402) being capable of storing data; and
a molding material (502) molded over said first surface (304), wherein said molding material (502) fills in and adheres to said perforations (308), and encapsulates said electrical components (402).

2. The storage device of claim 1, wherein at least one of said perforations (308) is capable of facilitating adhesion of said molding material (502) over said second surface (306), and wherein said molding material (502) is molded over said second surface (306).

3. The storage device of claim 1, wherein at least one of said perforations (308) is coated with an affinitive material, said affinitive material having an affinity for said molding material (502), said affinitive material comprising at least one of: silver, silver alloy, copper, copper alloy, nickel, nickel alloy, palladium, gold, gold alloy, and black oxide.

4. The storage device of claim 1, wherein said perforations (308) are curved in shape.

5. The storage device of claim 1, wherein said perforations (308) are polygonal in shape.

6. The storage device of claim 1, wherein said perforations (308) are located at a periphery of said base substrate (302).

7. The storage device of claim 1, wherein said base substrate (302) comprises an extended Printed Circuit Board (PCB), said extended PCB comprising one or more conductive strips capable of facilitating a Universal Serial Bus (USB) connection.

8. The storage device of claim 1 is a Chip-On-Board (COB) type device.

9. The storage device of claim 1 is a Surface Mount Technology (SMT) type device.

10. An article comprising:
a base substrate (102) comprising a first surface (104) and a second surface (106), said base substrate (102) further comprising one or more perforations (108) capable of facilitating adhesion of a molding material over said first surface (104);
one or more components (110) placed on said first surface (104) of said base substrate (102); and
a molding material (202) molded over said first surface (104), wherein said molding material (202) fills in and adheres to said perforations (108), and encapsulates said components (110).

11. The article of claim 10, wherein at least one of said perforations (108) is capable of facilitating adhesion of said molding material (202) over said second surface (106), and wherein said molding material (202) is molded over said second surface (106).

12. The article of claim 10, wherein at least one of said perforations (108) is coated with an affinitive material, said affinitive material having an affinity for said molding material (202), said affinitive material comprising at least one of: silver, silver alloy, copper, copper alloy, nickel, nickel alloy, palladium, gold, gold alloy, and black oxide.

13. The article of claim 10, wherein said perforations (108) are located at a periphery of said base substrate (102).

14. The article of claim 10 is a Chip-On-Board (COB) type device.

15. The article of claim 10 is a Surface Mount Technology (SMT) type device.
